Europäisches Patentamt

European Patent Office

Office européen des brevets

(11) Veröffentlichungsnummer: **0 132 622**
**A2**

(12) # EUROPÄISCHE PATENTANMELDUNG

(21) Anmeldenummer: 84107550.0

(51) Int. Cl.⁴: **H 03 M 1/66**

(22) Anmeldetag: 29.06.84

(30) Priorität: 23.07.83 DE 3326577
06.10.83 DE 3336370

(43) Veröffentlichungstag der Anmeldung:
13.02.85 Patentblatt 85/7

(84) Benannte Vertragsstaaten:
DE FR GB

(71) Anmelder: ROBERT BOSCH GMBH
Postfach 50
D-7000 Stuttgart 1(DE)

(72) Erfinder: Birmelin, Jörg, Ing. (grad.)
Carl-Schurz-Strasse 40
D-7530 Pforzheim(DE)

(72) Erfinder: Kohler, Rolf, Dipl.-Ing.
Breslauerstrasse 14
D-7141 Schwieberdingen(DE)

(72) Erfinder: Schmidt, Peter Jürgen, Dipl.-Ing.
Hermann-Essig-Strasse 106
D-7141 Schwieberdingen(DE)

(72) Erfinder: Wahl, Josef, Dipl.-Ing.
Schlossbergstrasse 4
D-7000 Stuttgart 80(DE)

(54) Digital/Analog-Wandelverfahren in Verbindung mit Sensor- und/oder Steuersignalen bei einem Kraftfahrzeug.

(57) Es wird ein Digital/Analog- Wandelverfahren vorgeschlagen, bei dem durch die Wiederholung umgewandelter digitaler Datenworte und nachfolgender Mittelwertbildung die Genauigkeit dieser umgewandelten Datenworte erhöht wird. Durch dieses Wandelverfahren wird der Vorteil der hohen Wiederholrate der käuflichen Digital/Analog- Wandler mit dem kostengünstigen Prinzip der Pulsbreitenmodulation vereinigt. Des weiteren werden Schaltungen vorgeschlagen, mit deren Hilfe das obige Digital/Analog- Wandelverfahren durchgeführt werden kann.

FIG. 1

R. 18818 i.P.

8.8.1983 Sr/Hm

ROBERT BOSCH GMBH, 7000 STUTTGART 1

**Digital/Analog-Wandelverfahren in Verbindung mit Sensor-
und/oder Steuersignalen bei einem Kraftfahrzeug**

Stand der Technik

Die Erfindung geht aus von einem Wandelverfahren nach der
Gattung des Hauptanspruchs. Für die Umwandlung eines digitalen Datenwortes in einen analogen Spannungswert steht
eine große Auswahl käuflicher Digital/Analog-Wandler
zur Verfügung. Diese können von einem Rechner angesteuert werden und besitzen eine hohe Wiederholrate für
aufeinanderfolgende Umwandlungen. Je mehr Bit das digitale Datenwort jedoch besitzt, je mehr Bit also auch
umgewandelt werden sollen, desto teurer wird der benötigte Digital/Analog-Wandler.

Es ist auch möglich, ein digitales Datenwort durch andauernden Vergleich mit dem momentanen Zählwert eines
Zählers in eine Folge von Tastverhältnissen umzuwandeln.
Dabei ergibt sich ein Signal konstanter Frequenz und
Amplitude, bei dem z.B. die Dauer des jeweils eingeschalteten Zustands dem digitalen Datenwort entspricht.

Mit Hilfe einer nachgeschalteten Pulsdauerspannungswandlung kann dann der analoge Spannungswert erzeugt
werden. Diese Umwandlung des digitalen Datenwortes in
ein Tastverhältnis erfordert einen geringen Aufwand an
Bauelementen, ist also billig, sie besitzt jedoch gleichzeitig nur eine niedere Wiederholrate von Umwandlungen,
da durch den Einsatz des Zählers und des nachzuschaltenden Pulsdauerspannungswandlers hohe Wandelzeiten pro
Umwandlung entstehen.

Vorteile der Erfindung

Das erfindungsgemäße Wandelverfahren mit den Merkmalen
des Hauptanspruchs hat demgegenüber den Vorteil, daß
die Verbindung eines käuflichen Digital/Analog-Wandlers
mit dem der Tastverhältniserzeugung zugrundeliegenden
Prinzip es ermöglicht, ein digitales Datenwort bei geringem Schaltungsaufwand schnell, genau und billig in
einen analogen Wert umzuwandeln. Das erfindungsgemäße
Wandelverfahren macht dabei keine Einschränkungen bezüglich der umzuwandelnden Bitstellen des digitalen
Datenworts, und auch eventuelle Anforderungen an den
analogen Wert können durch entsprechende schaltungstechnische Ausführungen des Verfahrens berücksichtigt werden.

Durch die in den Unteransprüchen aufgeführten Maßnahmen
sind vorteilhafte Weiterbildungen und Verbesserungen
des im Hauptanspruch angegebenen Wandelverfahrens
möglich.

Zeichnung

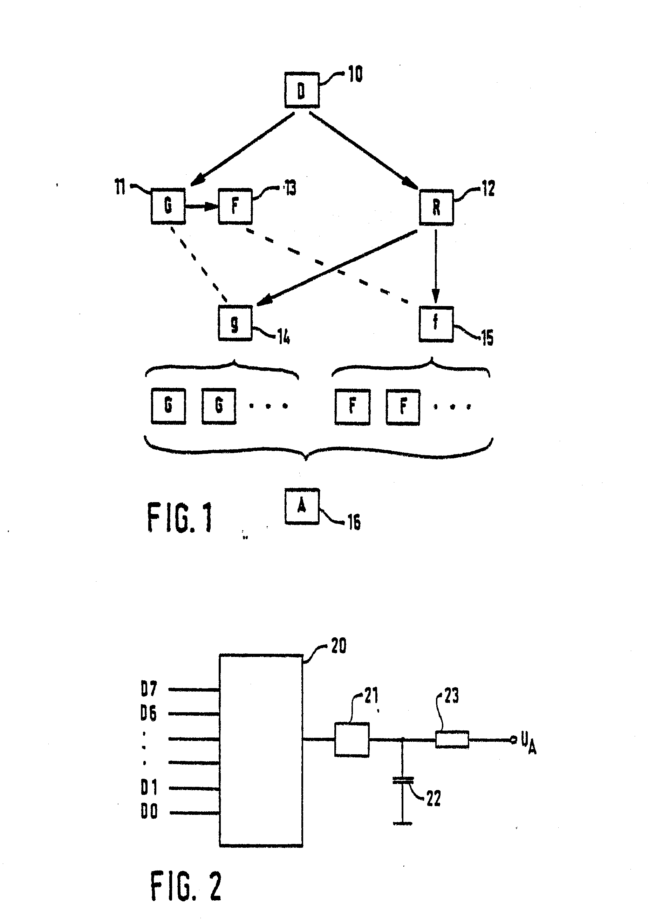

Die Figur 1 der Zeichnung ist ein Blockschaltbild des
Digital/Analog-Wandelverfahrens, Figur 2 bis Figur 5
zeigen Schaltungen zur Durchführung des Wandelverfahrens. Beides, das Blockschaltbild wie auch die Schaltungen, werden in der nachfolgenden Beschreibung näher erläutert.

Beschreibung des Ausführungsbeispiels

Figur 1 zeigt das Blockschaltbild des Digital/Analog-Wandelverfahrens. Ausgegangen wird bei dem Verfahren von dem digitalen Datenwort D 10. Dieses umzuwandelnde digitale Datenwort D wird nun in einen Grobwert G 11 und einen Rest R 12 so aufgespalten, daß die folgenden Gleichungen erfüllt sind:

$$D = G + R, \text{ wobei } D \geq 0; \quad G = 0, B, 2.B, 3.B, \ldots;$$
$$0 \leq R < B;$$
$$B = 1, 2, 3, \ldots \ .$$

Aus dem Grobwert G wird ein Folgewert F 13 gebildet, der sich um den Wert B vom Grobwert G unterscheidet. Es gilt also die Gleichung:

$$F = G + B.$$

Aus dem Rest R wird nun eine Anzahl von Wiederholungen g 14 des Grobwerts G und eine Anzahl von Wiederholungen f 15 des Folgewerts F abgeleitet. Dazu muß zuerst die Gesamtzahl von Wiederholungen n der Folge von Grobwerten G und Folgewerten F berechnet werden. Bezeichnet man die Anzahl der Bitstellen des eingesetzten käuflichen Digital/Analog-Wandlers und damit die Wandelfähigkeit dieses Digital/Analog-Wandlers mit s und die Anzahl der Bitstellen des digitalen Datenwortes D und damit die gewünschte Auflösung des Digital/Analog-Wandelverfahrens mit r, so gilt für die Gesamtzahl der Wiederholungen n der Folge von Grobwerten G und Folgewerten

F die folgende Gleichung:

$$n = 2^{r-s}, \text{ wobei } r \geq s; \quad 2^s > D + 1; \quad s \geq 1.$$

Zur Berechnung der Anzahl von Wiederholungen g des Grobwerts G wird ein Rundungswert W eingeführt, mit dessen Hilfe die Anzahl der Wiederholungen g auf einen ganzzahligen Wert auf- oder abgerundet wird. Für diese Anzahl der Wiederholungen des Grobwerts G gilt dann die folgende Gleichung:

$$g = ((B-R).n + W)/B, \text{ wobei } -0,5.B \leq W \leq + 0,5.B;$$
$$g = 0, 1, 2, \ldots .$$

Die Anzahl von Wiederholungen f des Folgewertes F wird nun folgendermaßen aus der Gesamtzahl von Wiederholungen n und der Anzahl von Wiederholungen g des Grobwerts G gebildet:

$$f = n - g.$$

Es wird nun eine Folge von Grobwerten G und Folgewerten F erzeugt, bei der die Anzahl der Grobwerte G dem Wert g entspricht, und die Anzahl der Folgewerte F dem Wert f. Jeder dieser Werte der Grobwerte G und Folgewerte F wird mittels des eingesetzten Digital/Analog-Wandlers umgewandelt. Der Mittelwert der Folge aus umgewandelten Grobwerten G und Folgewerten F ergibt dann einen analogen Wert A 16 gemäß der folgenden Gleichung:

$$A = (g. G + f. F)/n.$$

Dieser analoge Wert A unterscheidet sich von dem digitalen Datenwort D gemäß der folgenden Gleichung:

$$D - A = W/n.$$

- 5 -

Im folgenden soll anhand eines Beispiels, bei dem der
Wert B zu B = ' gewählt wird, das beschriebene Digital/
Analog-Wandelverfahren noch weiter veranschaulicht werden.
Das umzuwandelnde digitale Datenwort sei D = 43, 28. Die
Wandelfähigkeit des eingesetzten Digital/Analog-Wandlers
sei s = 6 Bitstellen. Die gewünschte Auflösung des
Wandelverfahrens sei r = 10 Bitstellen. Die Forderungen
$D \geq 0$, $r \geq s$, $s \geq 1$ und $2^s > D + 1$ sind damit erfüllt.
Für den Grobwert G ergibt sich der Wert G = 43, für den
Rest R der Wert R = 0,28. Damit sind auch die Gleichungen
D = G + R, G = 0,1, 2, ... und $0 \leq R < 1$ erfüllt. Für
die Gesamtzahl von Wiederholungen n der Folge von Grobwerten G und Folgewerten F gilt die Gleichung n = 16.
Die Anzahl von Wiederholungen g des Grobwerts G beträgt
dann g = 12, wobei der Rundungswert W den Wert W = 0,48
hat. Die Forderung $- 0,5 \leq W \leq +0,5$ ist somit auch erfüllt. Die Anzahl von Wiederholungen f des Folgewerts
F ergibt sich dann zu f = 4. Der Mittelwert der Folge
der parallel gewandelten Grobwerte G und Folgewerte F
ergibt dann den analogen Wert A zu A = 43, 25. Der Unterschied des digitalen Datenwortes D vom analogen Wert A
beträgt damit D - A = W/n = 0,03. Das digitale Datenwort
D ist damit durch den analogen Wert A angenähert worden.

Figur 2 bis Figur 4 zeigen Schaltungen zur Durchführung
des Wandelverfahrens. Dabei ist in Figur 2 die einfachste, dazu notwendige Schaltung dargestellt. Sie besteht
aus einem käuflichen Digital/Analog-Wandler und einem
nachgeschalteten RC-Filter. Die Eingänge des Digital/
Analog-Wandlers 20 werden von einem digitalen Wort
D7 D6 ... D1 D0 beaufschlagt. Der Ausgang des Wandlers
ist nach einer Schaltung zur Anpassung 21 zum einen
über eine Kapazität 22 mit Masse verbunden, zum anderen
ist er an einen Widerstand 23 angeschlossen, an dessen

...

- 6 -

anderem Ende die Spannung $U_A$ zur Verfügung steht. Das
Filter hat die Aufgabe, die Spannung zu glätten, die
am Ausgang des Wandlers durch eine eingangsseitige Folge
von digitalen Worten entsteht. Wird nun der Digital/
Analog-Wandler mit einer Folge von Grobwerten G und
Folgewerten F beaufschlagt, so steht als Spannung $U_A$
der analoge Wert A des digitalen Datenworts D zur Verfügung.

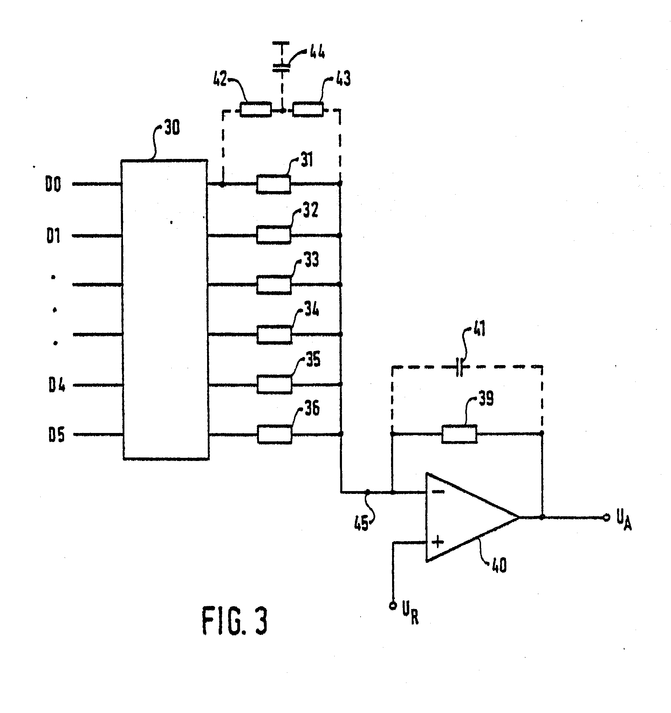

Die Figur 3 zeigt eine Schaltung zur Durchführung des
Wandelverfahrens, bei der der käufliche Digital/Analog-
Wandler durch eine Stromsummation ersetzt ist. Die
Schaltung besteht aus einer Kombination mehrerer D-
Flipflops 30, den Widerständen 31 bis 36, dem Rückkoppelwiderstand 39, dem Operationsverstärker 40, der Glättungskapazität 41 oder der Glättungsschaltung bestehend aus
den Widerständen 42, 43 und der Kapazität 44. Die Eingänge der D-Flipflops sind mit dem digitalen Wort D5 D4 ...
D1 D0 beaufschlagt. Die Ausgänge der D-Flipflops sind
jeweils mit einem der Widerstände 31 bis 36 verbunden,
deren jeweils anderes Ende zu einem Summationspunkt 45
führen. Das Verhältnis der Widerstände 31 bis 36 beträgt
dabei $2^5 : 2^4 : 2^3 : 2^2 : 2^1 : 1$. Dieses Verhältnis
stellt die Wertigkeit der einzelnen Bitstellen des digitalen Wortes dar und gewichtet die entsprechenden Ströme
entsprechend diesen Wertigkeiten. Der Summationspunkt 45
ist einerseits an den invertierenden Eingang des Operationsverstärkers 40 angeschlossen, andererseits über den
Widerstand 39 an den Ausgang des Operationsverstärkers
40 gekoppelt. Der nichtinvertierende Eingang des Operationsverstärkers wird mit einer Referenzspannung $U_R$ beaufschlagt. Am Ausgang des Operationsverstärkers 40 steht
die Ausgangsspannung $U_A$ zur Verfügung. Zur Glättung dieser

...

Ausgangsspannung $U_A$ kann nun entweder mit einer Glättungskapaziät 41 der Rückkopplungswiderstand 39 überbrückt werden, oder es wird der Widerstand 31 der
niederwertigsten Bitstelle des digitalen Wortes durch
eine Glättungsschaltung ersetzt, die aus einer T-
Schaltung aus den beiden Widerständen 42 und 43 und
der Kapazität 44 gegen Masse besteht. Es sei nun der
Widerstand 36 mit RO bezeichnet und der Widerstand 39
mit R1, weiter sei D5 das höchstwertigste Bit des digitalen
Wortes und DO das niederwertigste Bit und es seien die
Bits des digitalen Wortes jeweils entweder auf Massepotential oder auf dem Potential der Versorgungspannung
$U_B$. Für die Ausgangsspannung $U_A$ gilt dann die folgende
Gleichung:

$$U_A = U_R(63/32 \cdot R1/RO+1) - U_B \cdot R1/RO \cdot (D5+D4/2^1+...+D1/2^4+DO/2^5).$$

Wählt man das Verhältnis R1/RO zu R1/RO = 32/63, und die
Referenzspannung $U_R$ zu $U_R = U_B/2$, so ergibt sich die
Ausgangsspannung $U_A$ gemäß der folgenden Gleichung:

$$U_A = U_B \left(1 - \frac{32}{63}(D5 + D4/2^1 + ... + D1/2^4 + DO/2^5)\right).$$

Mit Hilfe der D-Flipflops, die das an ihren Eingängen
anliegende digitale Wort zwischenspeichern, und der
Glättungskapazität bzw. der Glättungsschaltung wird
nun eine Folge von digitalen Worten, mit denen die
D-Flipflops beaufschlagt werden, in eine Ausgangsspannung $U_A$ umgewandelt, die dem geglätteten Mittelwert
der digitalen Worte entspricht. Wie aus den beiden
obigen Gleichungen für diese Ausgangsspannung $U_A$ zu
ersehen ist, hat die beschriebene Schaltung der Figur 3
des weiteren noch eine umkehrende Wirkung auf die
Ausgangsspannung $U_A$. Der Vorteil der Glättungsschaltung

. . .

0132622

besteht darin, daß diese Schaltung nur das niederwertigste
Bit des digitalen Wortes glättet und nicht das gesamte
Wort. Dadurch wird erreicht, daß die Filterzeitkonstante
groß sein darf, ohne die Wandelzeit der Grobwerte zu verlangsamen.

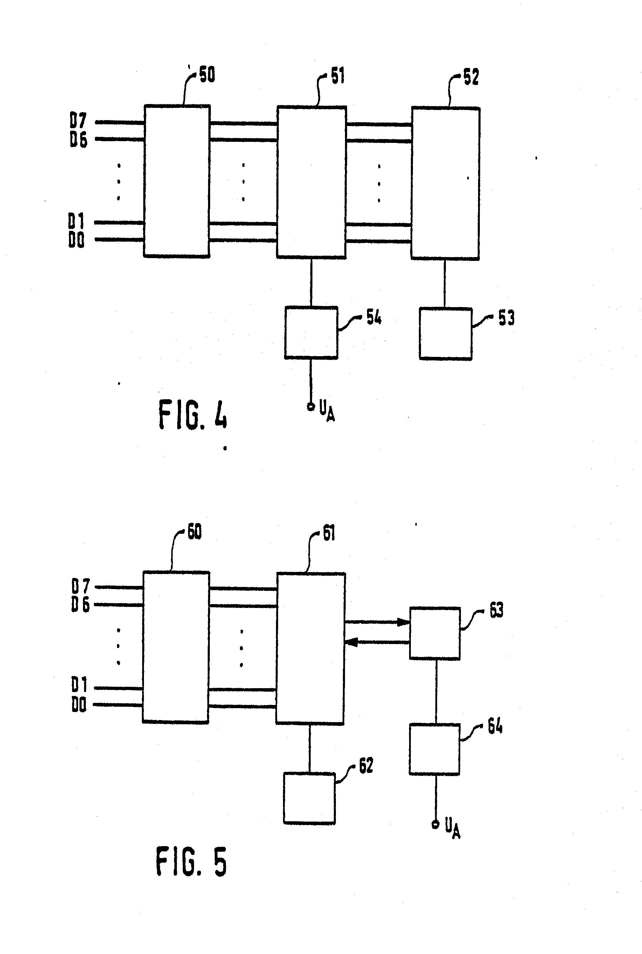

Figur 4 zeigt eine weitere Schaltung zur Durchführung
des Wandelverfahrens. Diese Schaltung besteht aus einer
Kombination mehrerer D-Flipflops 50, einem Komparator
51, einem Zähler 52, einer Takterzeugungseinrichtung 53
und einem Pulsdauerspannungswandler 54. Die D-Flipflops
sind an ihren Eingängen mit einem digitalen Wort D7 D6 ...
D1 DO beaufschlagt. Die Ausgänge der D-Flipflops sind mit
dem Komparator verbunden. Der Zähler ist mit der Takterzeugungseinrichtung gekoppelt und erhält von dort
seinen Zähltakt. Des weiteren sind die Ausgänge des
Zählers ebenfalls mit dem Komparator verbunden. Der Ausgang des Komparators ist an den Pulsdauerspannungswandler
angeschlossen, an dessen Ausgang die Spannung $U_A$ dann
zur Verfügung steht. Der Komparator erhält also zum
einen das von den D-Flipflops zwischengespeicherte digitale Wort, und zum anderen den momentanen Zählwert des
Zählers, der immer wieder von 0 bis $2^8 - 1$ aufwärts
zählt. Der Komparator vergleicht in jedem Moment das
digitale Wort und den momentanen Zählwert miteinander,
und erzeugt daraus ein Ausgangssignal, das zwei verschiedene Zustände haben kann. Ist das digitale Wort
größer oder gleich dem momentanen Zählerstand, so bleibt
das Ausgangssignal des Komparators in seinem ersten
Zustand. Wird jedoch das digitale Wort kleiner als der
momentane Zählerstand, so nimmt das Ausgangssignal des
Komparators seinen zweiten Zustand ein. Das Verhältnis
der Dauer der beiden Zustände entspricht also dem digitalen Wort an den Eingängen der D-Flipflops. Aus diesem
Verhältnis der Dauer der beiden Zustände des Ausgangs-

...

18818 i.P.
0132622

signals des Komparators erzeugt nun der nachfolgende
Pulsdauerspannungswandler eine dem Verhältnis entsprechende
Ausgangsspannung $U_A$. Der Pulsdauerspannungswandler hat
ebenfalls die Aufgabe, bei einer Folge von digitalen
Worten, mit denen die D-Flipflops beaufschlagt werden,
die Ausgangsspannung $U_A$ zu glätten. Die Spannung $U_A$ entspricht dann dem Mittelwert der Folge der digitalen Worte.

Figur 5 zeigt eine Schaltung zur Durchführung des Wandelverfahrens, die aus einer Kombination mehrerer D-Flipflops 60, einem Zähler 61, einer Takterzeugungseinrichtung 62, einer Einrichtung zur Erzeugung einer Pulsdauer 63 und einem Pulsdauerspannungswandler 64 besteht.
Die D-Flipflops sind dabei an ihren Eingängen mit dem
digitalen Wort D7 D6 ... D1 DO beaufschlagt, die Ausgänge der D-Flipflops sind mit dem Zähler verbunden. Der
Zähler wird dadurch mit dem von den D-Flipflops zwischengespeicherten digitalen Wort D7 D6 ... D1 DO geladen und
zählt von diesem Wert aus abwärts. Erreicht der Zähler
den Wert C, so gibt er ein Signal an die nachfolgende
Einrichtung zur Erzeugung einer Pulsdauer, wird gleichzeitig mit D7 D6 ... D1 DO erneut geladen und beginnt von
diesem Wert aus nun aufwärts zu zählen bis zum Überlauf,
gibt das Überlaufsignal an die Einrichtung zur Erzeugung
einer Pulsdauer, wird gleichzeitig erneut mit D7 D6 ...
D1 DO geladen und beginnt abermals abwärts zu zählen, usw.
Steht kein Vor-Rückwärtszähler zur Verfügung, wird der
Zähler abwechselnd mit D7 D6 ... D1 DO und dem Komplement
$\overline{D7 \ D6 \ ... \ D1 \ DO}$ geladen. Mit Hilfe der vom Zähler abgegebenen Signale wird von der nachfolgenden Einrichtung
eine Pulsdauer erzeugt, deren Dauer dem Wert des digitalen Wertes D7 D6 ... D1 DO entspricht. Diese Pulsdauer wird dann vom Pulsdauerspannungswandler in eine
entsprechende Ausgangsspannung $U_A$ umgewandelt. Der
Pulsspannungswandler hat ebenfalls die Aufgabe, die

...

0132622

Ausgangsspannung $U_A$ zu glätten. Die Spannung $U_A$ entspricht dann dem Mittelwert einer Folge von digitalen Worten, mit denen die D-Flipflops beaufschlagt werden.

Der Vorteil der beiden zuletzt beschriebenen Schaltungen besteht darin, daß die Genauigkeit der Schaltungen nur noch von der Genauigkeit der Takterzeugungseinrichtung abhängt, also z.B. von der Genauigkeit eines benutzten Quarzes.

Wird das digitale Datenwort schon in der Form einer Pulsdauer dem Digital/Analog-Wandelverfahren zur Verfügung gestellt, so reduzieren sich die beiden zuletzt beschriebenen Schaltungen auf den Pulsdauerspannungswandler und gegebenenfalls auf eine Glättung der erzeugten Ausgangsspannung $U_A$.

Für die Realisierung des Pulsdauerspannungswandlers gibt es verschiedene Möglichkeiten, z.B. auch ein als Integrator beschalteter Operationsverstärker.

Auch für die benutzten D-Flipflops können andere Schaltelemente benutzt werden, so z.B. Analogschalter, mechanische Schalter usw.

Es ist auch möglich, die beschriebenen Glättungsschaltungen und Filterschaltungen durch andere RC-Schaltungen zu ersetzen, oder, wenn sie nicht notwendig sind, ganz auf sie zu verzichten.

Eine Glättung des analogen Werts A des Digital/Analog-Wandelverfahrens ist auch dadurch möglich, daß die Anzahl g von Grobwerten G und die Anzahl f von Folgewerten F nicht hintereinander erzeugt wird, sondern daß die Grobwerte G und Folgewerte F gemischt werden.

...

Es besteht auch noch die Möglichkeit, das digitale Datenwort D so in einen Grobwert G und einen Rest R aufzuteilen, daß danach ein Folgewert F gebildet werden
kann, der um den Wert B kleiner ist als der Grobwert G.
Das Prinzip der Wiederholungen und der nachfolgenden
Mittelwertbildung wird durch eine derartige Umgestaltung nicht verändert.

Das beschriebene Digital/Analog-Wandelverfahren erzeugt
analoge Werte, die als Sensor - und/oder Steuersignale
weiterverwendet werden können. Beim Einsatz des Verfahrens in Kraftfahrzeugen kann eine Folge digitaler
Datenworte, die z.B. von einem Rechner gebildet werden
und mit denen z.B. die Kraftstoffzumessung beeinflußt
werden soll, in analoge Spannungswerte umgewandelt
werden, mit deren Hilfe dann z.B. ein Ventil in einem
Kraftstoffzumeßsystem angesteuert wird.

R. 18818 i.P.

8.9.1983 Sr/Hm


ROBERT BOSCH GMBH, 7000 STUTTGART 1


Ansprüche

1. Digital/Analog-Wandelverfahren in Verbindung mit
Sensor- und/oder Steuersignalen bei einem Kraftfahrzeug, dadurch gekennzeichnet, daß aus einem digitalen
Datenwort D ein ganzzahliger Grobwert G und ein Rest R,
der kleiner als ein Wert B ist, gebildet wird, daß ein
Folgewert F eingeführt wird, der sich vom Grobwert G um
den Wert B unterscheidet, daß jeweils eine Anzahl von
Wiederholungen g bzw. f des Grobwerts G bzw. des Folgewerts F erzeugt werden, daß die einzelnen Werte der
Folge von Grobwerten G und Folgewerten F in Analogwerte umgewandelt werden und daß der Mittelwert der
gewandelten Grobwerte G und Folgewerte F einen analogen Wert A darstellt, der eine Näherung des digitalen
Datenwortes D ist.


2. Digital/Analog-Wandelverfahren nach Anspruch 1,
dadurch gekennzeichnet, daß das umzuwandelnde digitale
Datenwort D folgendermaßen in den Grobwert G und den
Rest R aufgespalten wird:

$$D = G + R, \text{ wobei } D \geq 0; \quad G = 0, B, 2.B, 3.B, \ldots;$$
$$0 \leq R < B; \quad B = 1, 2, 3 \ldots .$$


3. Digital/Analog-Wandelverfahren nach Anspruch 2,
dadurch gekennzeichnet, daß der Folgewert F sich wie
folgt aus dem Grobwert G ergibt:

$$F = G + B.$$


. . .

4. Digital/Analog-Wandelverfahren nach Anspruch 3, dadurch gekennzeichnet, daß die Gesamtzahl von Wiederholungen n der Folge von Grobwerten G und Folgewerten F sich aus der gewünschten Auflösung des Digital/Analog-Wandelverfahrens r in Bitstellen und der Wandelfähigkeit des eingesetzten Digital/Analog-Wandlers s in Bitstellen gemäß der folgenden Gleichung berechnen läßt:

$$n = 2^{r-s}, \quad \text{wobei } r \geqslant s; \; 2^s > D + 1; \; s \geqslant 1.$$

5. Digital/Analog-Wandelverfahren nach Anspruch 4, dadurch gekennzeichnet, daß die Anzahl von Wiederholungen g des Grobwerts G folgendermaßen aus der Gesamtzahl von Wiederholungen n, dem Rest R und einem Rundungswert W errechnet wird, wobei der Rundungswert W so gewählt werden muß, daß die Anzahl von Wiederholungen g des Grobwerts G eine ganze Zahl ergibt:

$$g = ((B-R).n + W)/B, \quad \text{wobei} - 0,5.B \leqslant W \leqslant +0,5.B;$$
$$g = 0, 1, 2, \ldots .$$

6. Digital/Analog-Wandelverfahren nach Anspruch 5, dadurch gekennzeichnet, daß die Anzahl von Wiederholungen f des Folgewerts F wie folgt aus der Gesamtzahl von Wiederholungen n und der Anzahl von Wiederholungen g des Grobwerts G gebildet wird:

$$f = n - g.$$

7. Digital/Analog-Wandelverfahren nach wenigstens einem der Ansprüche 1 bis 6, dadurch gekennzeichnet, daß der sich als Mittelwert einer Folge von parallel gewandelten Grobwerten G und Folgewerten F ergebende analoge Wert A durch die folgende Gleichung beschreiben läßt:

$$A = (g . G + f . F)/n.$$

. . .

8. Digital/Analog-Wandelverfahren nach wenigstens einem der Ansprüche 1 bis 7, dadurch gekennzeichnet, daß der analoge Wert A, der die Näherung des digitalen Datenwortes D darstellt, sich folgendermaßen von diesem digitalen Datenwort D unterscheidet:

$D - A = W/n$.

9. Einrichtung zur Durchführung des Digital/Analog-Wandelverfahrens nach Anspruch 1, dadurch gekennzeichnet, daß ein digitales Datenwort mit Hilfe eines Digital/Analog-Wandlers in einen analogen Spannungswert umgewandelt wird und daß ein nachgeschaltetes Filter den Mittelwert über eine Folge von umgewandelten digitalen Datenworten bildet.

10. Einrichtung zur Durchführung des Digital/Analog-Wandelverfahrens nach Anspruch 1, dadurch gekennzeichnet, daß mit Hilfe eines als Summierer beschalteten Operationsverstärkers, bei dem die einzelnen Summiereingänge entsprechend ihrer Bitstellenwertigkeit gewichtet sind, ein digitales Datenwort in einen analogen Spannungswert umgewandelt wird und daß durch eine Glättungsschaltung der Mittelwert über eine Folge von umgewandelten digitalen Datenworten gebildet wird.

11. Einrichtung zur Durchführung des Digital/Analog-Wandelverfahrens nach Anspruch 1, dadurch gekennzeichnet, daß ein Komparator ein digitales Datenwort mit dem momentanen Zählerstand eines Zählers vergleicht, daß der Komparator daraus ein Tastverhältnis erzeugt, daß ein Pulsdauerspannungswandler mit diesem Tastverhältnis beaufschlagt wird, daß dieser Pulsdauerspannungswandler aus dem Tastverhältnis einen analogen Spannungswert ableitet, der dem digitalen Datenwort

. . .

0132622 i.P.

- 4 -

entspricht und daß der Pulsdauerspannungswandler des
weiteren noch den Mittelwert über eine Folge von
umgewandelten digitalen Datenworten bildet.

12. Einrichtung zur Durchführung des Digital/Analog-
Wandelverfahrens nach Anspruch 1, dadurch gekennzeichnet, daß ein Zähler eine nachgeschaltete Einrichtung so
ansteuert, daß diese aus dem am Zähler anliegenden digitalen Datenwert ein Tastverhältnis erzeugt, daß ein
Pulsdauerspannungswandler aus dem Tastverhältnis einen
analogen Spannungswert ableitet, der dem digitalen
Datenwort entspricht und daß der Pulsdauerspannungswandler des weiteren noch den Mittelwert über eine Folge
von umgewandelten digitalen Datenworten bildet.

13. Einrichtung nach wenigstens einem der Ansprüche
11 oder 12, dadurch gekennzeichnet, daß der Pulsdauerspannungswandler z. B. aus einem als Integrator beschalteten Operationsverstärker besteht.

14. Einrichtung nach wenigstens einem der Ansprüche 9,
10, 11 oder 12, dadurch gekennzeichnet, daß die digitale Datenworte z. B. von einem Rechner erzeugt werden
und daß die analogen Spannungswerte als Sensor- und/oder
Steuersignale weiterverwendet werden.

15. Einrichtung nach Anspruch 14, dadurch gekennzeichnet, daß die Sensor- und/oder Steuersignale für den
Betrieb von Einrichtungen in einem Kraftfahrzeug notwendig sind, z. B. für die Kraftstoffzumeßeinrichtung,
Leerlaufregulierung, Abgasrückführung usw. .

FIG. 1

FIG. 2

FIG. 3

0132622

FIG. 4

FIG. 5